# EUROPEAN PATENT APPLICATION

(11) **EP 4 832 700 A1**
(43) Date of publication of application: **28.10.2026**
(21) Application number: 25821064.0
(22) Date of filing: 23.05.2025
(51) Int. Cl.: H10F 77/70, H10F 77/14, H10F 71/00, H10F 10/14

(54) **SOLAR CELL AND PHOTOVOLTAIC MODULE**

(30) Priority: 14.06.2024 CN 202410777292
(71) Applicant: Zhejiang Aiko Solar Technology Co., Ltd, Jinhua, Zhejiang 322000 (CN); Guangdong Aiko Solar Technology Co., Ltd, Foshan, Guangdong 528000 (CN); Tianjin Aiko Solar Technology Co., Ltd, Tianjin 300400 (CN); Zhuhai Fushan Aiko Solar Technology Co., Ltd., Zhuhai, Guangdong 519000 (CN); Chuzhou Aiko Solar Technology Co., Ltd., Chuzhou, Anhui 239514 (CN); Shenzhen Aiko Digital Energy Engineering Co., Ltd, Shenzhen, Guangdong 518000 (CN)
(72) Inventor: DONG, Haiying, Jinhua, Zhejiang 322000 (CN); LI, Jingyu, Jinhua, Zhejiang 322000 (CN); SUN, Qinkang, Jinhua, Zhejiang 322000 (CN); LU, Cui, Jinhua, Zhejiang 322000 (CN); WANG, Yongqian, Jinhua, Zhejiang 322000 (CN); CHEN, Gang, Jinhua, Zhejiang 322000 (CN)
(74) Representative: EP&C
(86) International application number: PCT/CN2025/096966
(87) International publication number: WO 2025/256388

(57) **Abstract**

The present disclosure is applicable to the technical field of solar power generation, and provides a solar cell and a photovoltaic module. The solar cell includes a silicon substrate, wherein a first texture structure is disposed on a rear surface of the silicon substrate. A second texture structure is disposed on a side of the silicon substrate. The first texture structure and the second texture structure both present a frustum-like microstructure morphology. The first texture structure includes a plurality of first micro polygonal frustums. The second texture structure includes a plurality of second micro polygonal frustums. Sizes of the first micro polygonal frustums are smaller than those of the second micro polygonal frustums. By means of the above settings, the first texture structure is generated on a front, a back and the side of the silicon substrate by means of texturing, and then, the second texture structure is generated on the basis of the first texture structure on the side of the silicon substrate by means of further etching, so as to remove a material forming an emitter layer diffused to the side of the silicon substrate and a material forming a doped polysilicon layer, thereby preventing short circuits caused by the contact between the emitter layer and the doped polysilicon layer on the back at the side of the silicon substrate.

## Description

### CROSS-REFERENCE TO RELATED APPLICATIONS

The present disclosure claims the priority of Chinese patent application entitled "Solar Cell and Photovoltaic Module" submitted on June 14, 2024, with the application number of 202410777292.3, the entire contents of which are incorporated herein by reference.

### TECHNICAL FIELD

The present disclosure belongs to the technical field of solar power generation, and particularly relates to a solar cell and a photovoltaic module.

### BACKGROUND

A texturing process is involved in a process of fabricating a solar cell so as to produce an uneven textured surface on a surface of the solar cell. Due to the textured surface with a light trapping effect, the absorption of sunlight by a silicon wafer is increased while the reflectivity is reduced. Moreover, the surface area of the silicon wafer is increased, resulting in increased area of a PN junction, which in turn increases the short-circuit current and finally improves the photoelectric conversion efficiency of the cell.

It is necessary for depositing coating layers such as a tunnel layer, an emitter layer and a back surface field on a front and/or a back of a cell plate subjected to a texturing process. However, the coating layers such as the emitter layer and the back surface field may be in contact at a side of the cell plate during deposition, resulting in short circuits of the cell plate.

### SUMMARY

Embodiments of the present disclosure provide a solar cell, aiming to solve the problem of short circuits of an existing solar cell.

Embodiments of the present disclosure are achieved in such a way that a solar cell includes:
a silicon substrate, wherein a first texture structure is disposed on a rear surface of the silicon substrate, and a second texture structure is disposed on a side of the silicon substrate; and
the first texture structure and the second texture structure both present a frustum-like microstructure morphology, the first texture structure includes a plurality of first micro polygonal frustums, the second texture structure includes a plurality of second micro polygonal frustums, and sizes of the first micro polygonal frustums are smaller than those of the second micro polygonal frustums.

In some embodiments, the first micro polygonal frustums and the second micro polygonal frustums both have top surfaces, and the sizes of the first micro polygonal frustums and the sizes of the second micro polygonal frustums are any one of lengths of the corresponding top surfaces, widths of the top surfaces, lengths of engagement lines of the top surfaces and diameters of the top surfaces.

In some embodiments, the sizes of the first micro polygonal frustums are greater than or equal to 4 microns and less than 10 microns.

In some embodiments, the sizes of the second micro polygonal frustums are greater than or equal to 10 microns and less than or equal to 20 microns.

In some embodiments, the top surfaces of the first micro polygonal frustums and the top surfaces of the second micro polygonal frustums are any one of diamond, square, trapezoid and circle.

In some embodiments, the solar cell further includes a first anti-reflection layer, a first passivation layer, a first conduction type region, a second conduction type region and a second passivation layer; and
the first conduction type region, the first passivation layer and the first anti-reflection layer are successively arranged on a front surface of the silicon substrate, and the second conduction type region and the second passivation layer are successively arranged on the rear surface of the silicon substrate.

In some embodiments, the solar cell further includes a first tunnel layer, wherein the first tunnel layer is arranged between the first conduction type region and the silicon substrate.

In some embodiments, the solar cell further includes a second tunnel layer, wherein the second tunnel layer is arranged between the second conduction type region and the silicon substrate.

In some embodiments, the solar cell further includes a first doped layer, wherein the first doped layer is arranged between the silicon substrate and the first tunnel layer.

In some embodiments, the solar cell further includes a second doped layer, wherein the second doped layer is arranged between the silicon substrate and the second tunnel layer.

In some embodiments, the solar cell further includes a first electrode and a second electrode, wherein the first electrode is connected to the first conduction type region, and the second electrode is connected to the second conduction type region.

In a second aspect, the present disclosure further provides a photovoltaic module including the solar cell as described above.

The present disclosure has the beneficial effects that the solar cell of the present disclosure includes the silicon substrate, wherein the first texture structure is disposed on the rear surface of the silicon substrate, the second texture structure is disposed on the side of the silicon substrate, the first texture structure and the second texture structure both present the frustum-like microstructure morphology, the first texture structure includes a plurality of the first micro polygonal frustums, the second texture structure includes a plurality of the second micro polygonal frustums, and the sizes of the first micro polygonal frustums are smaller than those of the second micro polygonal frustums. By means of the above settings, the first texture structure is generated on the front, the back and the side of the silicon substrate by means of texturing, and then further coating layers are deposited, for example, an emitter layer is deposited on the front of the silicon substrate, or a tunnel layer and a doped polysilicon layer are deposited on the back of the silicon substrate. Then, the second texture structure is generated on the basis of the first texture structure on the side of the silicon substrate by means of further etching, so as to remove a material forming the emitter layer diffused to the side of the silicon substrate and a material forming the doped polysilicon layer, thereby preventing short circuits caused by the contact between the emitter layer and the doped polysilicon layer on the back at the side of the silicon substrate.

### BRIEF DESCRIPTION OF DRAWINGS

Fig. 1 is a schematic diagram showing a structure of a solar cell according to an embodiment of the present disclosure;
Fig. 2 is a schematic diagram of a first texture structure of a solar cell according to an embodiment of the present disclosure;
Fig. 3 is a schematic diagram of a second texture structure of a solar cell according to an embodiment of the present disclosure; and
Fig. 4 is a schematic diagram showing a structure of a solar cell according to another embodiment of the present disclosure.

### DETAILED DESCRIPTION OF EMBODIMENTS

In order to make the objectives, technical solutions and advantages of the present disclosure clearer, the present disclosure will be further described in detail below with reference to accompanying drawings and embodiments. Examples of embodiments described herein are shown in the accompanying drawings, in which the same or similar reference symbols denote the same or similar elements or elements having the same or similar functions throughout. Embodiments described below with reference to the accompanying drawings are exemplary, are provided merely for the purpose of illustrating the present disclosure, and should not be construed as a limitation to the present disclosure. Further, it should be understood that specific embodiments described herein are merely used for describing the present disclosure rather than limiting the present disclosure.

In the description of the present disclosure, it should be understood that orientational or positional relationships indicated by terms such as "length", "width", "upper", "lower", "left", "right", "horizontal", "top" and "bottom" are based on orientational or positional relationships shown in the accompanying drawings, are only for the purpose of facilitating the description of the present disclosure and simplifying the description, but are not intended to indicate or imply that the apparatus or component referred to must have a particular orientation or be constructed and operated in a particular orientation. Therefore, such terms should not be construed as a limitation to the present disclosure.

In addition, terms "first" and "second" are used for a descriptive purpose only and should not be construed as indicating or implying relative importance or implying a quantity of technical features indicated. Thereby, a feature defined by "first" or "second" may explicitly or implicitly include one or more of such features. In the description of the present disclosure, "a plurality of" means two or more, unless otherwise explicitly and particularly defined.

In the description of the present disclosure, it should be noted that, unless otherwise explicitly specified or defined, terms such as "install", "connect" and "connection" shall be construed broadly. For example, they may be a fixed connection, a detachable connection, or an integral connection; they may be a mechanical connection, an electrical connection or a mutual communication; and they can be a direct connection or an indirect connection via an intermediate medium, and they can be an internal communication between two components or an interaction relationship between the two components. Specific meanings of the above terms in the present disclosure may be understood depending on specific circumstances for those ordinarily skilled in the art.

In the present disclosure, unless otherwise expressly specified or defined, a first feature being "on" or "under" a second feature may involve the first feature being in contact with the second feature, or the first feature is not in direct contact with the second feature but rather is in contact with the second feature through a further feature therebetween. Moreover, the first feature being "on", "above", and "over" the second feature involves the first feature being directly above and obliquely above the second feature, or simply indicates that the first feature is horizontally higher than the second feature. The first feature being "under", "below" and "underneath" the second feature involves the first feature being directly below and obliquely below the second feature, or simply indicates that the first feature is horizontally lower than the second feature.

The description below provides a number of different embodiments or examples to implement different structures of the present disclosure. In order to simplify the description of the present disclosure, parts and settings of specific examples will be described below. Certainly, they are only examples and are not intended to limit the present disclosure. In addition, reference numbers and/or reference letters may be repeated in different examples of the present disclosure, and such a repetition is for the purposes of simplification and clarity and does not in itself indicate the relationship between various embodiments and/or settings in question. Further, although the present disclosure provides examples of various specific processes and materials, applications of other processes and/or use of other materials can occur in those ordinarily skilled in the art.

A solar cell of the present disclosure includes a silicon substrate, wherein a first texture structure is disposed on a rear surface of the silicon substrate, a second texture structure is disposed on a side of the silicon substrate, the first texture structure and the second texture structure both present the frustum-like microstructure morphology, the first texture structure includes a plurality of first micro polygonal frustums, the second texture structure includes a plurality of second micro polygonal frustums, and sizes of the first micro polygonal frustums are smaller than those of the second micro polygonal frustums. By means of the above settings, the first texture structure is generated on a front, a back and the side of the silicon substrate by means of texturing, and then further coating layers are deposited, for example, an emitter layer is deposited on the front of the silicon substrate, or a tunnel layer and a doped polysilicon layer are deposited on the back of the silicon substrate. Then, the second texture structure is generated on the basis of the first texture structure on the side of the silicon substrate by means of further etching, so as to remove a material forming the emitter layer diffused to the side of the silicon substrate and a material forming the doped polysilicon layer, thereby preventing short circuits caused by the contact between the emitter layer and the doped polysilicon layer on the back at the side of the silicon substrate.

### Embodiment 1

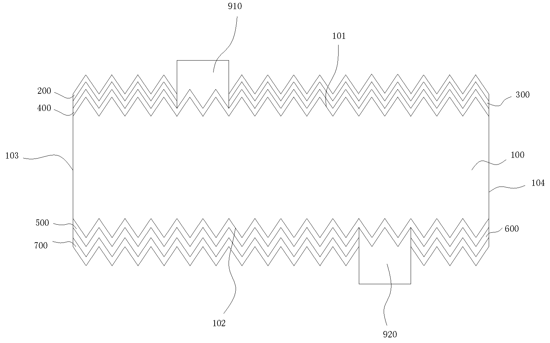

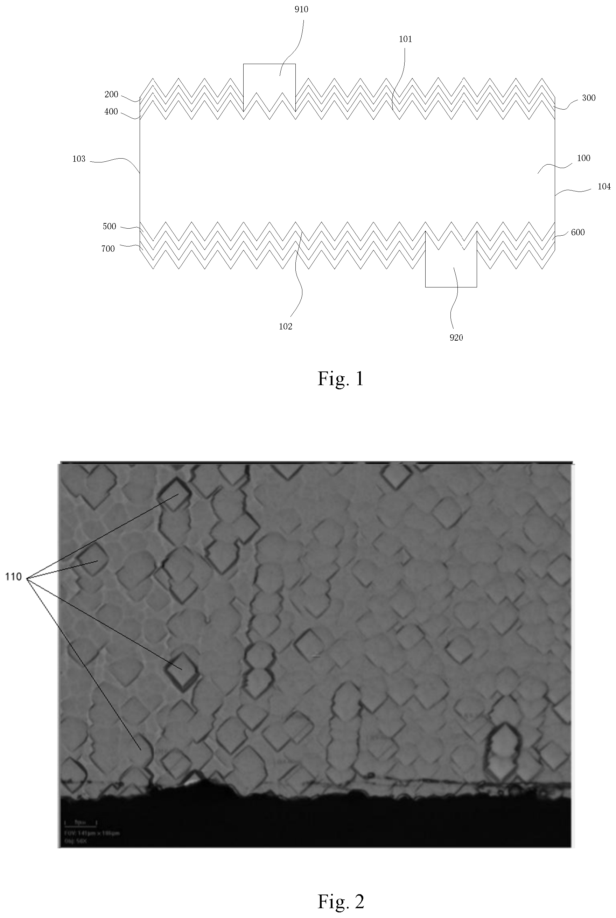

As shown in Fig. 1 to Fig, 4, an embodiment of the present disclosure provides a solar cell, including:
a silicon substrate 100, wherein a first texture structure 110 is disposed on a rear surface of the silicon substrate 100, and a second texture structure 120 is disposed on a side of the silicon substrate 100; and
the first texture structure 110 and the second texture structure 120 both present a frustum-like microstructure morphology, the first texture structure 110 includes a plurality of first micro polygonal frustums, the second texture structure 120 includes a plurality of second micro polygonal frustums, and sizes of the first micro polygonal frustums are smaller than those of the second micro polygonal frustums.

In practice, the solar cell provided by the present disclosure is a cell respectively provided with coating layers opposite in polarity on the front and the back of the silicon substrate 100. Exemplarily, taking a PERC (Passivated Emitter and Rear Cell) cell as an example, the PERC cell includes a front metal electrode, a front anti-reflection layer, an emitter region, a silicon substrate 100, a back surface field, a back anti-reflection layer and a back metal electrode which are distributed from top to bottom, wherein the emitter region and the back surface field are located on the front and the back of the silicon substrate 100, respectively, the front metal electrode is connected to the emitter region and serves as an anode, and the back metal electrode is connected to the back surface field and serves as a cathode.

It should be noted that the PERC cell may further include further coating layers, such as a passivation layer, which will be omitted here.

In a traditional process of fabricating a solar cell, the first texture structure 110 is generated on a back of the silicon substrate 100 by means of texturing, and then the emitter region and the back surface field are generated on the front and the back of the silicon substrate 100 by employing LPCVD (Low-Pressure Chemical Vapor Deposition) equipment. Certainly, the emitter region and the back surface field may be generated by employing further approaches without being restricted to the LPCVD equipment, for example, the emitter region and the back surface field are generated on the front and the back of the silicon substrate 100 by employing PVD (Physical Vapor Deposition) equipment, without limitations. The emitter region and the back surface field generated may be connected at the side of the silicon substrate 100, resulting in short circuit, wherein the side of the silicon substrate 100 is a face between the front and the back of the silicon substrate 100, as shown in Fig. 1. The silicon substrate 100 has the front 101 and the back 102. The side of the silicon substrate 100 is a side 103 and a side 104, respectively.

When the first texture structure 110 is generated on the back of the silicon substrate 100 by means of texturing while the first texture structure 110 is generated on the side of the silicon substrate 100, the first texture structure 100 is a frustum-shaped microstructure morphology, and the first texture structure 110 includes a plurality of first micro polygonal frustums, as shown in Fig. 2. The polygonal frustums are non-pyramid structures, such as cone frustums, approximate cone frustums, tetrahedrons, approximate tetrahedrons, pentahedra or approximate pentahedrons, without limitations.

Optionally, the texturing includes but is not limited to chemical etching, laser etching, mechanical treatment, plasma etching, and the like, without limitations.

The first texture structure 110 on the back of the silicon substrate 100 enables a silk-screen printing metal paste to be filled in microstructures when forming electrodes, resulting in excellent electrode contact, which can effectively reduce the series resistance of the cell and improve the filling factor.

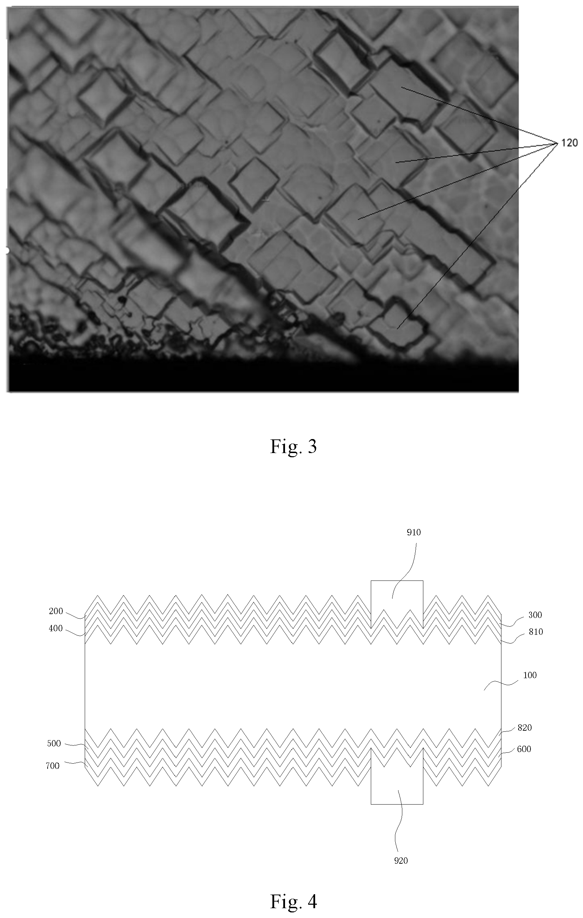

The side of the silicon substrate 100 is etched for a second time after the emitter region and the back surface field generated. That is, the second texture structure 120 is generated on the basis of the first texture structure 110 on the side of the silicon substrate 100 by further etching, and the second texture structure 120 includes a plurality of second micro polygonal frustums, as shown in Fig. 3. An etching manner is a manner of generating the first texture structure 110 by means of the etching, which will be omitted here.

Since the second micro polygonal frustums are generated on the basis of the first micro polygonal frustums by secondary etching. That is, the second micro polygonal frustums are generated on the basis of the first micro polygonal frustums by means of the further etching, such that the sizes of the second micro polygonal frustums are larger than those of the first micro polygonal frustums.

The polygonal frustums have top surfaces, for example, the top surfaces of the first micro polygonal frustums and the top surfaces of the second micro polygonal frustums are any one of diamond, square, trapezoid and circle.

The sizes of the polygonal frustums are any one of lengths of the top surfaces, widths of the top surfaces, lengths of engagement lines of the top surfaces and diameters of the top surface. In some further embodiments, the sizes of the polygonal frustums may be any one of lengths, widths, diagonal lengths and bottom diameters of bottoms of the polygonal frustums, without limitations. It should be noted that sizes of the top surfaces of the first micro polygonal frustums are compared with those of the top surfaces of the second micro polygonal frustums in terms of the same category, for example, the lengths of the engagement lines of the top surfaces of the first micro polygonal frustums are less than those of the engagement lines of the top surfaces of the second micro polygon frustums.

Optionally, the sizes of the first micro polygonal frustums are greater than or equal to 10 microns and less than 10 microns. The sizes of the second micro polygonal frustums are greater than or equal to 10 microns and less than or equal to 20 microns. Exemplarily, taking the first micro polygonal frustum as a first triangular pyramidal frustum and the second micro polygonal frustum as a second triangular pyramidal frustum as an example, the triangular pyramidal frustum includes a top surface and three side surfaces. A size of the top surface of the first triangular pyramidal frustum is indicated as a, and a size of the top surface of the second triangular pyramidal frustum is indicated as b, wherein a is greater than or equal to 4 microns and less than 10 microns, and b is greater than or equal to 10 microns and less than or equal to 20 microns. Exemplarily, taking a side length of the top surface as an example, the side length of the top surface of the first triangular pyramidal frustum can be 4 microns, 5 microns, 6 microns, 7 microns, 8 microns or 9 microns, and the side length of the top surface of the second triangular pyramidal frustum can be 10 microns, 12 microns, 13 microns, 15 microns, 19 microns or 20 microns, without limitations.

In some embodiments, the sizes of the polygonal frustums can refer to vertical distances from the top surfaces to the bottoms of the polygonal frustums, that is, the sizes of the polygonal frustums refer to heights of the polygonal frustums, which will be omitted.

It should be understood that the number of the micro polygonal frustums formed on the back can be inexhaustible due to the anisotropy of a crystal orientation of a back silicon crystal, and the sizes of the micro polygonal frustums referred to in the present disclosure can be an average value of the sizes of the top surfaces of the micro polygonal frustums randomly selected in a specific region to characterize texture features of the micro polygonal frustums.

The solar cell of the present disclosure includes the silicon substrate 100, wherein the first texture structure 110 is disposed on the rear surface of the silicon substrate 100, the second texture structure 120 is disposed on the side of the silicon substrate 100, the first texture structure 110 and the second texture structure 120 both present the frustum-like microstructure morphology, the first texture structure 110 includes a plurality of the first micro polygonal frustums, the second texture structure 120 includes a plurality of the second micro polygonal frustums, and the sizes of the first micro polygonal frustums are smaller than those of the second micro polygonal frustums. By means of the above settings, the first texture structure 110 is generated on the front, the back and the side of the silicon substrate 100 by means of the texturing, and then the further coating layers are deposited, for example, the emitter layer is deposited on the front of the silicon substrate 100, or the tunnel layer and the doped polysilicon layer are deposited on the back of the silicon substrate 100. Then, the second texture structure 120 is generated on the basis of the first texture structure 110 on the side of the silicon substrate 100 by means of further etching to remove the material forming the emitter layer diffused to the side of the silicon substrate 100 and the material forming the doped polysilicon layer, thereby preventing short circuits caused by the contact between the emitter layer and the doped polysilicon layer on the back at the side of the silicon substrate 100.

In some alternate embodiments, the solar cell further includes a first anti-reflection layer 200, a first passivation layer 300, a first conduction type region 400, a second conduction type region 500 and a second passivation layer 600; and
the first conduction type region 400, the first passivation layer 300 and the first anti-reflection layer 200 are successively arranged on the front surface of the silicon substrate 100, and the second conduction type region 500 and the second passivation layer 600 are successively arranged on the rear surface of the silicon substrate 100.

In practice, the front surface and the rear surface of the silicon substrate 100 are a front and a back of the silicon substrate 100, respectively. Exemplarily, taking the front of the silicon substrate 100 facing upwards as an example, the first conduction type region 400, the first passivation layer 300 and the first anti-reflection layer 200 are successively disposed from bottom to top on the front of the silicon substrate 100, while the second conduction type region 500 and the second passivation layer 600 are successively disposed from top to bottom on the back of the silicon substrate 100.

Optionally, the first conduction type region 400 and the second conduction type region 500 may include the emitter region and the back surface field region, wherein the emitter region refers to a portion drawing electrons out of the solar cell. In general, the emitter region is also considered to be an "anode" of the solar cell. Similarly, the back surface field region is generally an aluminum back surface field in the solar cell, and mainly functions to reflect long waves, reduce transmission of light, perform heavy doping on the back, carry out passivation and gettering, prolong the minority carrier lifetime and increase an open-circuit voltage. The back surface field region is generally considered as a "cathode" of the solar cell, which will be omitted.

In some embodiments, one of the first conduction type region 400 and the second conduction type region 500 is the emitter region and the other one is the back surface field region. In an embodiment of the present disclosure, terms such as "first" or "second" are used only to distinguish components, but not limited to this in such embodiments of the present disclosure.

In some possible embodiments, the silicon substrate 100 may include a base region containing a dopant of a first conduction type with a relatively low doping concentration. The base region can be composed of a crystal semiconductor containing the dopant of the first conduction type. For example, the base region can include a monocrystalline semiconductor or a polycrystalline semiconductor (for example, monocrystalline silicon or polycrystalline silicon) containing the dopant of the first conduction type. Optionally, the base region can be composed of the monocrystalline semiconductor (for example, a monocrystalline semiconductor wafer, more particularly, a semiconductor silicon wafer) containing the dopant of the first conduction type. Therefore, when the base region is composed of the monocrystalline silicon, the solar cell constitutes a monocrystalline silicon solar cell. Accordingly, the solar cell including the monocrystalline semiconductor is based on the base region or silicon substrate 100 and have few defects due to excellent crystallinity, thereby exhibiting excellent electrical property.

Exemplarily, the dopant of the first conduction type is an n-type dopant or a p-type dopant. For example, the dopant of the first conduction type can be an n-type impurity such as group-V elements including phosphorus (P), arsenic (As), bismuth (Bi), antimony (Sb) and the like). Or, the dopant of the first conduction type can be a p-type impurity such as group-III elements (including boron (B), aluminum (Al), gallium (Ga), indium (In) and the like).

Similarly, the base region can include the n-type impurity as the dopant of the first conduction type while the emitter region forming a p-n junction with the base region is p-type. When light is emitted to the p-n junction, electrons generated by a photoelectric effect move towards the back of the silicon substrate 100 and then are collected by corresponding electrodes. Holes move towards the front of the silicon substrate 100 and then are collected by the corresponding electrodes. In this way, electrical energy is generated. The holes with low movement velocity move towards the front of the silicon substrate 100, so as to improve the photoelectric conversion efficiency. However, embodiments of the present disclosure are not limited to this. For example, in further embodiments of the present disclosure, the base region and the back surface field region can be designed as the p-type, and the emitter region can be designed as n-type, without limitations.

In some embodiments, the silicon substrate 100 may include only the base region without an additional doped region. That is, a doped region with different conduction types from the silicon substrate 100 or a doped region with the same conduction type as the silicon substrate 100 and relatively high doping concentration is formed on the silicon substrate 100 in the traditional solar cell.

As described above, the silicon substrate 100 consists of the base region without an additional doped region. For example, the difference between the lowest doping concentration and the highest doping concentration in the silicon substrate 100 is less than or equal to 10%, for example, 9%, 8% or 6%, without limitations.

Both the first passivation layer 300 and the second passivation layer 600 are passivation layers used to improve the photoelectric conversion efficiency and the stability of the solar cell, reduce the surface damage and the oxidation reaction of the solar cell, and prolong the service life of the solar cell.

In some possible embodiments, the passivation layer includes titanium dioxide, aluminum oxide and ferric oxide, without limitations. Preferably, the first passivation layer 300 and/or the second passivation layer 600 can use the aluminum oxide to ensure the light absorption rate.

The first anti-reflection layer 200 is an anti-reflection layer. Optionally, the first anti-reflection layer 200 can be composed of a silicon nitride layer, a silicon oxynitride layer and a silicon oxide layer, without limitations.

In some possible embodiments, the solar cell provided by the present disclosure further includes a second anti-reflection layer 700, wherein the second anti-reflection layer 700 is arranged on a side of the second passivation layer 600 away from the second conduction type region 500, and the second anti-reflection layer 700 may be composed of a silicon nitride layer, a silicon oxynitride layer and a silicon oxide layer, without limitations.

The anti-reflection layer, also known as a reflection reducing layer, is used to reduce or eliminate reflected light from optical surfaces such as a lens, a prism and a mirror, thereby increasing the amount of transmitted light of these components and reducing or eliminating stray light from a system.

In some embodiments, the solar cell provided by the present disclosure further includes a first tunnel layer 810, wherein the first tunnel layer 810 is arranged between the first conduction type region 400 and the silicon substrate 100.

In practice, photons excite electrons located on one side and push them towards the tunnel layer when entering the solar cell. In the tunnel layer, the electrons pass through a bandgap through a tunneling effect and reach the other side of the solar cell. These electrons can generate an electric current or voltage, thereby converting light energy into electric energy. The tunneling effect improves the electron transporting efficiency by reducing the height of the electrons across an energy barrier, thereby improving the efficiency of the solar cell. That is, the tunneling layer functions to improve the electron transporting efficiency, i.e., increase the efficiency of the solar cell.

The first tunnel layer 810 is formed on the front of the silicon substrate 100. The first tunnel layer 810 passivates a surface of the silicon substrate 100 with a plurality of composite sites, and facilitates the migration of carriers through the tunneling effect.

Optionally, the first tunnel layer 810 may include a material providing passivation and the tunneling effect, such as oxides, nitrides, semiconductors and conductive polymers. For example, the first tunnel penetration layer 810 can include silicon oxide, silicon nitride, silicon oxynitride, intrinsic amorphous silicon and intrinsic polycrystalline silicon, without limitations.

In some embodiments, the solar cell provided by the present disclosure further includes a second tunnel layer 820, wherein the second tunnel layer 820 is arranged between the second conduction type region 500 and the silicon substrate 100. The second tunnelling layer 820 may refer to the first tunnel layer 810, which will be omitted here.

In some embodiments, the solar cell further includes a first doped layer, wherein the first doped layer is arranged between the silicon substrate 100 and the first tunnel layer 810.

In practice, the first doped layer involves forming a thin layer of dopant (such as boron and phosphorus) on the solar cell plate by a sputtering or chemical deposition method to increase the thickness of an effective layer during subsequent epitaxial growth so as to improve the efficiency of the solar cell.

In some embodiments, the solar cell further includes a second doped layer, wherein the second doped layer is arranged between the silicon substrate 100 and the second tunnel layer 820. The second doped layer may refer to the first doped layer as described above, which will be omitted here.

It should be noted that the first doped layer and the second doped layer have the same doping polarity as that on the same surface, for example, the first doped layer has the same doping type as that of the first conduction type region 400, and the second doped layer has the same doping type as that of the second conduction type region 500, which will be omitted here.

In some embodiments, the solar cell further includes a first electrode 910 and a second electrode 920, wherein the first electrode 910 is connected to the first conduction type region 400, and the second electrode 920 is connected to the second conduction type region 500.

In practice, both the first passivation layer 300 and the first anti-reflection layer 200 are provided with openings. The first electrode 910 is electrically connected to the first conduction type region 400 via the openings provided by the first passivation layer 300 and the first anti-reflection layer 200. That is, the first electrode 910 is connected to the first conduction type region 400 after passing through the first anti-reflection layer 200 and the first passivation layer 300. Similarly, both the second passivation layer 600 and the second anti-reflection layer 700 are provided with openings. The second electrode 920 is electrically connected to the second conduction type region 500 via the openings provided by the second passivation layer 600 and the second anti-reflection layer 700. That is, the second electrode 920 is connected to the second conduction type region 500 after passing through the second anti-reflection layer 700 and the second passivation layer 600. The first electrode 910 and the second electrode 920 can be made of various conductive materials (such as copper or silver) into various shapes, such as strips, sheets or other shapes, without limitations.

### Embodiment 2

In some alternate embodiments, the present disclosure further provides a photovoltaic module including the solar cell as described above.

It should be appreciated for those skilled in the field that for the sake of convenience and brevity in description, a structure and an implementation principle of the photovoltaic module described above can correspondingly refer to the structure and the implementation principle in the aforementioned embodiment 1, which will be omitted here.

The solar cell of the present disclosure includes the silicon substrate 100, wherein the first texture structure 110 is disposed on the rear surface of the silicon substrate 100, the second texture structure 120 is disposed on the side of the silicon substrate 100, the first texture structure 110 and the second texture structure 120 both present the frustum-like microstructure morphology, the first texture structure 110 includes a plurality of the first micro polygonal frustums, the second texture structure 120 includes a plurality of the second micro polygonal frustums, and sizes of the first micro polygonal frustums are smaller than those of the second micro polygonal frustums. By means of the above settings, the first texture structure 110 is generated on the front, the back and the side of the silicon substrate 100 by means of the texturing, and then further coating layers are deposited, for example, the emitter layer is deposited on the front of the silicon substrate 100, or the tunnel layer and the doped polysilicon layer are deposited on the back of the silicon substrate 100. Then, the second texture structure 120 is generated on the basis of the first texture structure 110 on the side of the silicon substrate 100 by further etching, so as to remove the material forming the emitter layer diffused to the side of the silicon substrate 100 and the material forming the doped polysilicon layer, thereby preventing short circuits caused by the contact between the emitter layer and the doped polysilicon layer on the back at the side of the silicon substrate 100.

The above embodiments are preferred embodiments of the present disclosure, and are not intended to limit the present disclosure. Any modifications, modifications, equivalent substitutions or improvements made within the spirit and principles of the present disclosure should be included within the scope of protection of the present disclosure.

## Claims

1. A solar cell, comprising:
a silicon substrate, wherein a first texture structure is disposed on a rear surface of the silicon substrate, and a second texture structure is disposed on a side of the silicon substrate; and
the first texture structure and the second texture structure both present a frustum-like microstructure morphology, the first texture structure comprises a plurality of first micro polygonal frustums, the second texture structure comprises a plurality of second micro polygonal frustums, and sizes of the first micro polygonal frustums are smaller than sizes of the second micro polygonal frustums.

2. The solar cell according to claim 1, wherein the first micro polygonal frustums and the second micro polygonal frustums both have top surfaces, and the sizes of the first micro polygonal frustums and the sizes of the second micro polygonal frustums are any one of lengths of the corresponding top surfaces, widths of the top surfaces, lengths of engagement lines of the top surfaces and diameters of the top surfaces.

3. The solar cell according to any one of claims 1 to 2, wherein the sizes of the first micro polygonal frustums are greater than or equal to 4 microns and less than 10 microns.

4. The solar cell according to claim 3, wherein the sizes of the second micro polygonal frustums are greater than or equal to 10 microns and less than or equal to 20 microns.

5. The solar cell according to claim 1, wherein the top surfaces of the first micro polygonal frustums and the top surfaces of the second micro polygonal frustums are any one of diamond, square, trapezoid and circle.

6. The solar cell according to claim 1, further comprising a first anti-reflection layer, a first passivation layer, a first conduction type region, a second conduction type region and a second passivation layer; and
the first conduction type region, the first passivation layer and the first anti-reflection layer are successively arranged on a front surface of the silicon substrate, and the second conduction type region and the second passivation layer are successively arranged on the rear surface of the silicon substrate.

7. The solar cell according to claim 6, further comprising a first tunnel layer, wherein the first tunnel layer is arranged between the first conduction type region and the silicon substrate.

8. The solar cell according to claim 6, further comprising a second tunnel layer, wherein the second tunnel layer is arranged between the second conduction type region and the silicon substrate.

9. The solar cell according to claim 7, further comprising a first doped layer, wherein the first doped layer is arranged between the silicon substrate and the first tunnel layer.

10. The solar cell according to claim 8, further comprising a second doped layer, wherein the second doped layer is arranged between the silicon substrate and the second tunnel layer.

11. The solar cell according to any one of claims 6 to 10, further comprising a first electrode and a second electrode, wherein the first electrode is connected to the first conduction type region, and the second electrode is connected to the second conduction type region.

12. A photovoltaic module, comprising the solar cell according to any one of claims 1 to 11.
